(19) Europäisches Patentamt
European Patent Office
Office européen des brevets

(11) EP 2 671 920 A1

(12) EUROPEAN PATENT APPLICATION
published in accordance with Art. 153(4) EPC

(43) Date of publication:
11.12.2013 Bulletin 2013/50

(21) Application number: 12741911.7

(22) Date of filing: 31.01.2012

(51) Int Cl.:
C08L 63/00 (2006.01)
C08G 59/40 (2006.01)
C08K 5/53 (2006.01)
C08L 79/08 (2006.01)
C09J 11/06 (2006.01)
C09J 163/00 (2006.01)
C09J 179/08 (2006.01)
H05K 1/03 (2006.01)

(86) International application number:
PCT/JP2012/052144

(87) International publication number:
WO 2012/105558 (09.08.2012 Gazette 2012/32)

(84) Designated Contracting States:
AL AT BE BG CH CY CZ DE DK EE ES FI FR GB GR HR HU IE IS IT LI LT LU LV MC MK MT NL NO PL PT RO RS SE SI SK SM TR

(30) Priority: 01.02.2011 JP 2011019705

(71) Applicant: DIC Corporation
Tokyo 174-8520 (JP)

(72) Inventors:
- MURAKAMI, Kouichi
Sakura-shi
Chiba 285-8668 (JP)
- ICHINOSE, Eijyu
Sakura-shi
Chiba 285-8668 (JP)
- MIYAGAKI, Atsushi
Sakura-shi
Chiba 285-8668 (JP)
- MIHARA, Takashi
Sakura-shi
Chiba 285-8668 (JP)
- HAZAMA, Masaki
Sakura-shi
Chiba 285-8668 (JP)

(74) Representative: Albrecht, Thomas
Kraus & Weisert
Patent- und Rechtsanwälte
Thomas-Wimmer-Ring 15
80539 München (DE)

# (54) THERMOSETTING RESIN COMPOSITION, CURED PRODUCT THEREOF, AND INTERLAYER ADHESIVE FILM FOR PRINTED WIRING BOARD

(57) There is provided a thermosetting polyimide resin composition which enables production of a cured product exhibiting excellent dimensional stability and which exhibits excellent meltability at low temperature in a semicured state (in the B-stage) and excellent flame resistance in a completely cured state; there are also provided a cured product of such a composition and an interlaminar adhesive film used for a printed wiring board, the interlaminar adhesive film being formed of the composition. In particular, there are provided a thermosetting polyimide resin composition containing a thermosetting polyimide resin (A) having a biphenyl backbone directly linked to a nitrogen atom of a five-membered cyclic imide backbone and a weight-average molecular weight (Mw) of 3,000 to 150,000, a phosphorus compound (B) represented by specific Formula (bl) or (b2), and an epoxy resin (C); a cured product of such a composition; and an interlaminar adhesive film used for a printed wiring board, the interlaminar adhesive film including a layer formed of the composition, the layer being formed on a carrier film.

EP 2 671 920 A1

## Description

### Technical Field

The present invention relates to a thermosetting polyimide resin composition which enables production of a cured product exhibiting excellent dimensional stability and which exhibits excellent meltability at low temperature in a semi-cured state (in the B-stage) and excellent flame resistance in a completely cured state. The present invention also relates to a cured product of such a composition and an interlaminar adhesive film used for a printed wiring board, the interlaminar adhesive film being formed of the composition.

### Background Art

In recent years, a demand for semiconductor components having a smaller thickness, light weight, and high packing density has been increased, and it is expected that the wiring density of circuit boards will be further increased. In order to increase wiring density, for example, wiring boards are laminated to impart a three-dimensional structure to a circuit. It is expected that the number of layers to be laminated will be 10 or more in future; however, with an increase in the number of layers to be laminated, strain and stress are generated in a circuit due to a difference in thermal expansion between an insulating layer and copper foil, which has become problematic. Hence, the thermal expansion of the insulating layer needs to be reduced.

In general, however, resins exhibiting low linear expansion have poor melt-processability, and curable compositions containing such resins are unsuitable for a multilayer process for forming circuit boards, which has been problematic. Accordingly, development of a resin which satisfies the requirements of both low thermal expansion and melt-processability has been particularly strongly desired in the industry.

A resin composition which preferably contains a polyamide-imide resin having a glass transition temperature of 330°C (VYLOMAX HR16NN manufactured by TOYOBO CO., LTD.), diphenylethanebismaleimide (BMI-70 manufactured by K.I Chemical Industry Co., Ltd.), and an allylphenol resin (MEH-8000H manufactured by Showa Kasei Kogyo Co., Ltd.) is disclosed as a resin composition which enables production of a cured product having, in addition to melt-processability, a good mechanical strength, adhesive strength to a target object, film formability, thermal resistance, and pressure resistance (see Patent Literature 1). However, since this resin composition contains a thermoplastic polyamide-imide resin having a high molecular weight, the resin composition exhibits poor meltability at low temperature and is less compatible with a maleimide compound; hence, phase separation occurs in curing of a coating film in some cases, which causes a problem in which it is difficult to uniformly form a coating film or in which use of a solvent having a high boiling point, such as NMP, may cause the composition in the B-stage to contain a residual solvent. This problem has an adverse effect such as expansion or peeling of a coating film thermally pressed against a substrate in the B-stage; in addition, the allylphenol resin content in the resin composition causes a cured coating film to be fragile, and thus the film is less flexible.

A resin composition containing a siloxane-modified polyimide, 2,2-bis(4-hydroxy-3-allylphenyl)propane, and diphenylethanebismaleimide is disclosed as a resin composition which enables production of a cured product exhibiting good adhesion to a target object. However, since a siloxane backbone is introduced into the imide resin, the linear expansion coefficient of such a resin composition is increased; hence, the resin composition also has problems such as low dimensional stability and poor adhesion to a variety of substrates made of, for example, metal, plastic materials, or inorganic materials.

### Citation List

#### Patent Literature

PTL 1: Japanese Unexamined Patent Application Publication No. 2004-168894 (page 10)
PTL 2: Japanese Unexamined Patent Application Publication No. 2000-223805 (page 18)

### Summary of Invention

#### Technical Problem

It is an object of the present invention to provide a thermosetting polyimide resin composition which enables production of a cured product exhibiting excellent dimensional stability and which exhibits excellent meltability at low

temperature in a semi-cured state (in the B-stage) and excellent flame resistance in a completely cured state; it is another object of the present invention to provide a cured product of such a composition and an interlaminar adhesive film used for a printed wiring board, the interlaminar adhesive film being formed of the composition.

Solution to Problem

The inventors have intensely conducted studies and made the following findings to accomplish the present invention: a composition which contains a thermosetting polyimide resin that is a polyimide resin having a biphenyl backbone directly linked to a five-membered cyclic imide backbone and a weight-average molecular weight (Mw) of 3,000 to 150,000, a phosphorus compound having a phosphaphenanthrene structure, and an epoxy resin enables production of a cured product having a low linear expansion coefficient and excellent dimensional stability, enables a production of a cured product exhibiting excellent meltability at low temperature in the B-stage, and enables a production of a cured product exhibiting good flame resistance.

In particular, an aspect of the present invention provides a thermosetting polyimide resin composition containing a thermosetting polyimide resin (A) having a biphenyl backbone directly linked to a nitrogen atom of a five-membered cyclic imide backbone and a weight-average molecular weight (Mw) of 3,000 to 150,000, a phosphorus compound (B) represented by Formula (b1) or (b2), and an epoxy resin (C)

[Chem. 1]

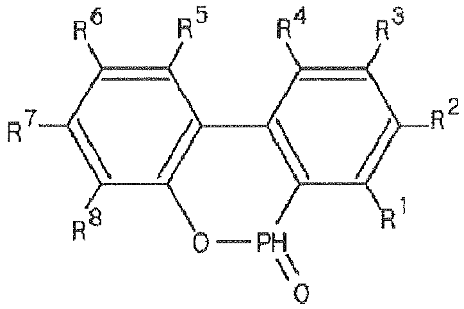

(b1)

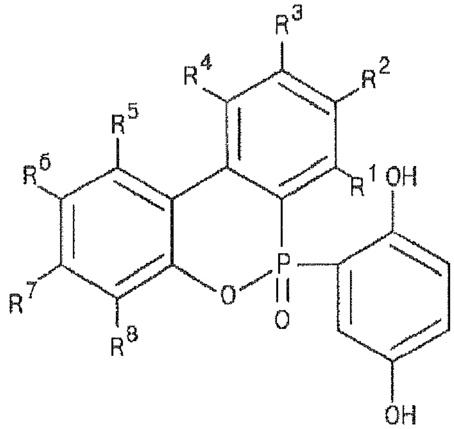

(b2)

where $R^1$, $R^2$, $R^3$, $R^4$, $R^5$, $R^6$, $R^7$, and $R^8$ each represent a monofunctional aliphatic group or aromatic group.

Another aspect of the present invention provides a cured product produced by curing the thermosetting polyimide resin composition.

Another aspect of the present invention provides an interlaminar adhesive film used for a printed wiring board, the interlaminar adhesive film including a layer formed of the thermosetting polyimide resin composition, the layer being formed on a carrier film.

Advantageous Effects of Invention

According to an aspect of the present invention, although the thermosetting polyimide resin composition exhibits excellent meltability at low temperature after the B-stage, the cured product thereof has a low linear expansion coefficient

and excellent dimensional stability. In addition, a cured product exhibiting excellent flame resistance can be produced. The cured product having such properties can be used in a variety of applications. Specific examples of applications in which the cured product can be used include coating agents used in the peripheral parts of engines, slide parts, HDD slide parts, voice coils, electromagnetic coils, and a variety of films, coating agents for insulating electric wires, and coating agents which need to have thermal resistance, flame resistance, and insulating properties for use in, e.g., heating cookers; a variety of electronic materials such as fiber reinforced composite materials, e.g., carbon fiber prepreg, insulating materials used for printed wiring boards and semiconductor devices, surface protecting layers such as a coverlay and a solder resist, buildup materials, resins for prepreg, insulating materials used for flexible displays, insulating layers of organic TFTs, buffer coats, semiconductor coats such as Low-k materials, polymer waveguides, sealing materials used for semiconductor devices, and adhesives such as underfill materials; a variety of materials used in the field of the energy industry, such as solar batteries, lithium batteries, capacitors, insulating films of, e.g., electric double layer capacitors, electrode binders, and separators; and laser printers, endless belts such as transfer belts or fixing belts of copying machines, coating agents used therefor, conductive films, binders used in heat releasing films, alignment films used for color filters, and overcoat films. In particular, the cured product can be preferably used for insulating layers and solder resists of, for example, multilayer printed wiring boards. According to another aspect of the present invention, in use of the interlaminar adhesive film used for a printed wiring board, the interlaminar adhesive film is press-bonded to copper foil while being melted at low temperature, so that an insulating layer in which a cured product has a low linear expansion coefficient can be formed. Hence, the interlaminar adhesive film used for a printed wiring board can be preferably used as an adhesive film to form an interlayer insulator of a multilayer printed wiring board. Description of Embodiments

A thermosetting polyimide resin (A) has a weight-average molecular weight (Mw) of 3,000 to 150,000. At a weight-average molecular weight (Mw) less than 3,000, a cured product in the B-stage exhibits poor flexibility, and this weight-average molecular weight is therefore not preferred. At a weight-average molecular weight (Mw) more than 150,000, melt viscosity is increased with the result that melting is prevented; hence, a cured product in the B-stage exhibits poor meltability at low temperature, and this weight-average molecular weight is therefore not preferred. The weight-average molecular weight (Mw) is preferably in the range of 5,000 to 50,000.

In the present invention, weight-average molecular weight (Mw) is measured by gel permeation chromatography (GPC) under the following conditions.

Measuring equipment: HLC-8320GPC, UV8320 manufactured by TOSOH CORPORATION
Column: two columns of SuperAWM-H manufactured by TOSOH CORPORATION
Detector: RI (refractive index detector) and UV (254 nm) Data processing: EcoSEC-WorkStation manufactured by TOSOH CORPORATION
Measurement conditions: Column temperature 40°C
Mobile phase DMF
Flow rate 0.35 ml/min
Standard: Calibration curve is defined by using a polystyrene standard sample
Sample: Produced by filtering a DMF solution containing 0.2 weight% of a resin solid content through a micro filter (amount: 10 $\mu$l)

The thermosetting polyimide resin (A) has biphenyl backbones directly linked to an imide backbone. The inventor believes that such a structure imparts excellent dimensional stability to a cured produced formed by curing the thermosetting polyimide resin composition of the present invention.

The biphenyl backbone exhibits good compatibility with the aromatic rings contained in a maleimide compound (B) which will be described later. Hence, the thermosetting imide resin composition of the present invention enables production of a cured product having excellent dimensional stability. In addition, the inventor believes that a cured product in the B-stage exhibits good meltability at low temperature because the maleimide compound (B) having a low molecular weight intrudes into the thermosetting polyimide resin (A) having a rigid structure and molecules which are less likely to move.

The biphenyl backbone content in the thermosetting polyimide resin (A) is preferably from 20 to 45 mass%, more preferably 25 to 40 mass%, and further preferably 25 to 35 mass% because it enables production of a cured product exhibiting good dimensional stability and also because a cured product in the B-stage has excellent meltability at low temperature.

The biphenyl structure content can be calculated from the proportion of the biphenyl structures in the total weight of the polyimide resin on the assumption that biphenyl structures linked to two parts of the main chain of the polyimide resin have a molecular weight of 152 and that biphenyl structures linked to four parts thereof have a molecular weight of 150.

The thermosetting polyimide resin (A) having a logarithmic viscosity of 0.1 to 0.9 dl/g contributes to production of a thermosetting imide resin composition which enables production of a cured product having a sufficient strength and

which exhibits good meltability at low temperature in the B-stage; hence, such a logarithmic viscosity is preferred. The logarithmic viscosity of the thermosetting polyimide resin (A) is more preferably 0.2 to 0.8 dl/g, and further preferably 0.3 to 0.7 dl/g.

In the present invention, the logarithmic viscosity of the thermosetting polyimide resin (A) is determined as follows.

The polyimide resin is dissolved in N-methyl-2-pyrrolidone to a resin concentration of 0.5 g/dl to produce a resin solution. The solution viscosity of the resin solution and the viscosity of the solvent (viscosity of N-methyl-2-pyrrolidone) are measured at 30°C with an Ubbelohde viscometer, and the obtained values are put into the following formula to determine the logarithmic viscosity of the thermosetting polyimide resin (A).

$$\text{Logarithmic viscosity (dl/g)} = [\ln(V1/V2)]/V3$$

In the formula, V1 represents a solution viscosity measured with an Ubbelohde viscometer, and V2 represents the viscosity of the solvent measured with an Ubbelohde viscometer. In this case, V1 and V2 are obtained from time over which the resin solution and the solvent (N-methyl-2-the pyrrolidone) have passed through the capillary of the Ubbelohde viscometer. V3 is the concentration (g/dl).

Examples of the thermosetting polyimide resin (A) include polyimide resins having the following structures.

[Chem. 2]

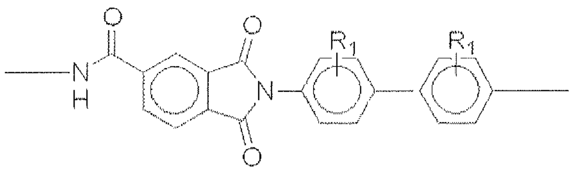

---(a1)

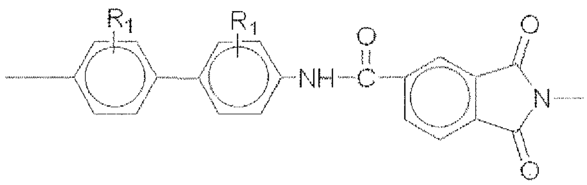

---(a2)

(where $R_1$ represents a hydrogen atom or an alkyl group which may be substituted with a halogen atom such as a fluorine atom; both the structures (a1) and (a2) may be present, but the structure (a1) is essential to the resin.)

Examples of the polyimide resins having the structures (a1) and (a2) include polyimide resins having the following structures.

[Chem. 3]

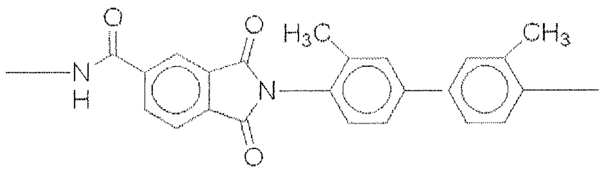

---(a1-1)

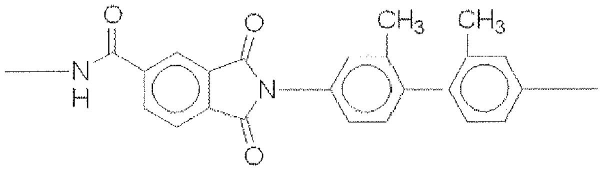

---(a1-2)

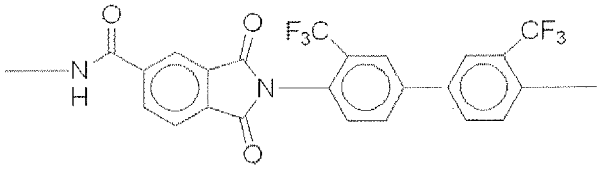

---(a1-3)

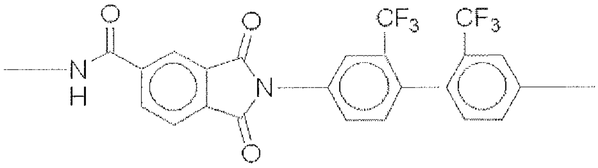

---(a1-4)

[Chem. 4]

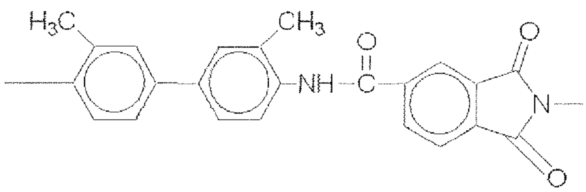

---(a2-1)

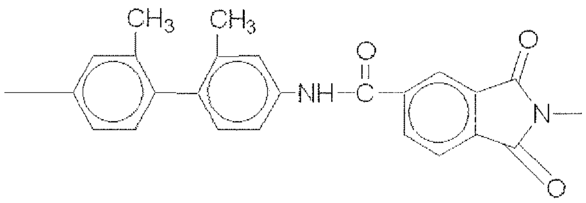

---(a2-2)

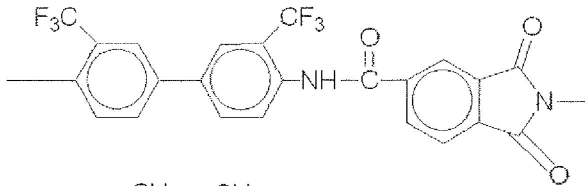

---(a2-3)

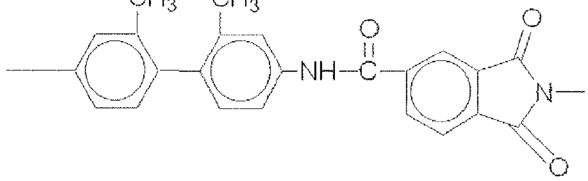

---(a2-4)

The thermosetting polyimide resin (A) can be easily prepared by, for example, a technique which involves allowing a polyisocyanate having a biphenyl backbone to react with an acid anhydride. In such production of the thermosetting polyimide resin (A), for instance, a polyisocyanate compound having a biphenyl backbone (a1) and/or an acid anhydride having a biphenyl backbone (a2) are appropriately allowed to react with a polyisocyanate compound (a3) other than the polyisocyanate compound (a1) or an acid anhydride (a4) other than the acid anhydride (a2).

In this case, in place of the polyisocyanate compound (a1) and the polyisocyanate compound (a3), polyamine compounds having the main structures the same as those of the compounds (a1) and (a3) may be used and allowed to react with the acid anhydride (a2) or the acid anhydride (a4) to produce similar imide resins.

Examples of the polyisocyanate compound (a1) having a biphenyl backbone include 4,4'-diisocyanate-3,3'-dimethyl-1,1'-biphenyl, 4,4'-diisocyanate-3,3'-diethyl-1,1'-biphenyl, 4,4'-diisocyanate-2,2'-dimethyl-1,1'-biphenyl, 4,4'-diisocyanate-2,2'-diethyl-1,1'-biphenyl, 4,4'-diisocyanate-3,3'-ditrifluoromethyl-1,1'-biphenyl, and 4,4'-diisocyanate-2,2'-ditrifluoromethyl-1,1'-biphenyl.

Examples of the acid anhydride (a2) having a biphenyl backbone include biphenyl-3,3',4,4'-tetracarboxylic acid, biphenyl-2,3,3',4'-tetracarboxylic acid, and mono- and dianhydrides thereof, and these materials may be used alone or in combination.

Examples of the polyisocyanate compound (a3) other than the polyisocyanate compound (a1) include aromatic polyisocyanates other than the polyisocyanate compound (a1) and aliphatic polyisocyanates.

Examples of aromatic polyisocyanates other than the polyisocyanate compound (a1) include p-phenylene diisocyanate, m-phenylene diisocyanate, p-xylene diisocyanate, m-xylene diisocyanate, 2,4-tolylene diisocyanate, 2,6-tolylene diisocyanate, 4,4'-diphenylmethane diisocyanate, 3,3'-dimethyldiphenyl-4,4'-diisocyanate, 3,3'-diethyldiphenyl-4,4'-diisocyanate, 1,3-bis($\alpha$,$\alpha$-dimethylisocyanatomethyl)benzene, tetramethylxylylene diisocyanate, diphenylene ether-4,4'-diisocyanate, and naphthalene diisocyanate.

Examples of the aliphatic polyisocyanate compounds include hexamethylene diisocyanate, lysine diisocyanate, trimethylhexamethylene methylene diisocyanate, isophorone diisocyanate, 4,4'-dicyclohexylmethane diisocyanate, hydrogenated xylene diisocyanate, and norbornene diisocyanate.

An isocyanate prepolymer produced by allowing the above-described polyisocyanate compound to react with polyol components in advance under a condition in which isocyanate groups are in excess may be used as the polyisocyanate compound, and the polyisocyanate compound may be modified with, for example, a biuret, isocyanurate, carbodiimide, or uretdione.

The thermosetting polyimide resin (A) is preferably a thermosetting polyimide resin produced by the reaction of a polyisocyanate having a biphenyl backbone with an acid anhydride; in particular, the polyisocyanate having a biphenyl backbone, which is used for synthesizing the thermosetting polyimide resin (A), is preferably tolidine diisocyanate or polyisocyanate derived from tolidine diisocyanate.

The thermosetting polyimide resin (A) may have a branched structure, which enhances solubility in solvents and compatibility with other resins. In order to impart a brunched structure to the thermosetting polyimide resin (A), for example, a tri- or higher functional polyisocyanate compound having an isocyanurate ring, which is an isocyanurate of the above-described diisocyanate compound or another compound; a biuret, adduct, or allophanate of the above-described diisocyanate; polymethylene polyphenyl polyisocyanate (crude MDI); or another material may be used as the polyisocyanate compound.

Examples of the acid anhydride (a4) other than the acid anhydride (a2) include aromatic tricarboxylic acid anhydrides other than the acid anhydride (a2), alicyclic tricarboxylic acid anhydrides, and tetracarboxylic acid anhydrides other than the acid anhydride (a2). Examples of the aromatic tricarboxylic acid anhydride other than the acid anhydride (a2) include trimellitic anhydride and naphthalene-1,2,4-tricarboxylic acid anhydride.

Examples of the alicyclic tricarboxylic acid anhydrides include cyclohexane-1,3,4-tricarboxylic acid-3,4-anhydride, cyclohexane-1,3,5-tricarboxylic acid-3,5-anhydride, and cyclohexane-1,2,3-tricarboxylic acid-2,3-anhydride.

Examples of the tetracarboxylic acid anhydrides other than the acid anhydride (a2) include pyromellitic acid dianhydride, benzophenone-3,3',4,4'-tetracarboxylic acid dianhydride, diphenyl ether-3,3',4,4'-tetracarboxylic acid dianhydride, benzene-1,2,3,4-tetracarboxylic acid dianhydride, naphthalene-2,3,6,7-tetracarboxylic acid dianhydride, naphthalene-1,2,4,5-tetracarboxylic acid dianhydride, naphthalene-1,4,5,8-tetracarboxylic acid dianhydride, decahydronaphthalene-1,4,5,8-tetracarboxylic acid dianhydride, 4,8-dimethyl-1,2,3,5,6,7-hexahydronaphthalene-1,2,5,6-tetracarboxylic acid dianhydride, 2,6-dichloronaphthalene-1,4,5,8-tetracarboxylic acid dianhydride, 2,7-dichloronaphthalene-1,4,5,8-tetracarboxylic acid dianhydride, 2,3,6,7-tetrachloronaphthalene-1,4,5,8-tetracarboxylic acid dianhydride, phenanthrene-1,3,9,10-tetracarboxylic acid dianhydride, perylene-3,4,9,10-tetracarboxylic acid dianhydride, bis(2,3-dicarboxyphenyl)methane dianhydride, bis(3,4-dicarboxyphenyl)methane dianhydride, 1,1-bis(2,3-dicarboxyphenyl)ethane dianhydride, 1,1-bis(3,4-dicarboxyphenyl)ethane dianhydride, 2,2-bis(2,3-dicarboxyphenyl)propane dianhydride, 2,3-bis (3,4-dicarboxyphenyl)propane dianhydride, bis(3,4-dicarboxyphenyl)sulfone dianhydride, bis(3,4-dicarboxyphenyl)ether dianhydride,

ethylene glycol-bis(anhydrotrimellitate), propylene glycol-bis(anhydrotrimellitate), butanediol-bis(anhydrotrimellitate), hexamethylene glycol-bis(anhydrotrimellitate), polyethylene glycol-bis(anhydrotrimellitate), polypropylene glycol-bis(anhydrotrimellitate), and other alkylene glycol-bis(anhydrotrimellitate).

The thermosetting polyimide (A) is more preferably a polyimide resin having a benzophenone structure, which further develops thermal resistance and low linear expansion. The polyimide resin having a benzophenone structure can be produced by, for instance, using a benzophenonetetracarboxylic anhydride as an essential component in the above-mentioned preparation technique.

The benzophenone structure content is, on the basis of the mass of the polyimide resin, preferably from 1 to 30 mass% because it enables production of a cured product having an excellent thermal resistance and is more preferably from 5 to 20 mass% because it enables highly stable synthesis.

The benzophenone structure content can be calculated from the proportion of the benzophenone structure in the total weight of the polyimide resin on the assumption that benzophenone structures linked to four parts of the main chain of the polyimide resin have a molecular weight of 178.

The thermosetting polyimide (A) is further preferably a polyimide resin having a tolylene structure because melt adhesion and low linear expansion are readily developed. The polyimide resin having a tolylene structure can be produced by, for instance, using toluene diisocyanate as an essential component in the above-mentioned preparation technique.

The tolylene structure content can be calculated from the proportion of the tolylene structure in the total weight of the polyimide resin on the assumption that a tolylene structure in the main chain of the polyimide resin has a molecular weight of 150.

The tolylene structure content in the polyimide resin is preferably in the range of 1 to 20 mass% because it enables highly stable synthesis and more preferably in the range of 2 to 14 mass% because it enables low linear expansion and highly stable synthesis.

In the above-mentioned preparation technique, the polyisocyanate compound reacts with a compound having an acid anhydride group. The ratio (ma)/(mb) of the number of moles (ma) of the isocyanate group in the polyisocyanate compound to the total number of moles (mb) of the acid anhydride group and carboxyl group in the compound having an acid anhydride group is preferably from 0.7 to 1.2 and more preferably from 0.8 to 1.2 because a polyimide resin having a high molecular weight is easily produced and such a polyimide resin enables production of a cured product having good mechanical properties. The ratio (ma)/(mb) is further preferably in the range of 0.9 to 1.1 because it enables easy production of a polyimide resin having high storage stability. In the case where other carboxylic acid anhydrides, such as trimellitic anhydride, are used in combination, the (mb) is the total number of moles of the acid anhydride groups and carboxyl groups in all the carboxylic acid anhydrides.

In the case where the preparation is carried out through a single-step reaction in the above-mentioned preparation technique, for example, a polyisocyanate compound and a compound having an acid anhydride group are put in a reactor, and the reaction is allowed to proceed while performing decarboxylation by increasing the temperature under stirring.

The reaction temperature can be in the range of 50°C to 250°C and preferably in the range of 70°C to 180°C in terms of a reaction rate and prevention of a side reaction.

The reaction is preferably allowed to proceed until the reaction of the isocyanate group has been substantially completed because the stability of the polyimide resin to be produced is improved. An alcohol or a phenol compound may be added to induce a reaction with a slightly remaining isocyanate group.

In the production of the thermosetting polyimide resin (A), an organic solvent can be preferably used to induce a homogeneous reaction. Such an organic solvent may be added in a system before the reaction proceeds or may be added during the reaction. In order to maintain a proper reaction rate, the proportion of the organic solvent in the reaction system is preferably not more than 98 mass%, more preferably from 10 to 90 mass%, and further preferably 40 to 90 mass%. Since a compound having an isocyanate group is used as a raw material component, such an organic solvent is preferably a polar aprotic organic solvent which does not contain an active proton of, for example, a hydroxyl group or an amino group.

Examples of the polar aprotic organic solvent include polar organic solvents such as dimethylformamide, dimethylacetamide, N-methyl-2-pyrrolidone, dimethyl sulfoxide, sulfolane, and γ-butyrolactone. In addition to the above-mentioned solvents, for example, ether solvents, ester solvents, ketone solvents, and petroleum solvents may be used provided that the polyimide resin is soluble therein. A variety of solvents may be used in combination.

In particular, in view of the drying properties of a coating film containing such a solvent, a reduction in the amount of the residual solvent in curing of the coating film, and solubility of the polyimide resin, dimethylacetamide is preferably employed.

Examples of the ether solvents that can be used in the method for preparing the polyimide resin used in the present invention include ethylene glycol dialkyl ethers such as ethylene glycol dimethyl ether, ethylene glycol diethyl ether, and ethylene glycol dibutyl ether; polyethylene glycol dialkyl ethers such as diethylene glycol dimethyl ether, diethylene glycol diethyl ether, diethylene glycol dibutyl ether, triethylene glycol dimethyl ether, triethylene glycol diethyl ether, and triethylene glycol dibutyl ether; ethylene glycol monoalkyl ether acetates such as ethylene glycol monomethyl

ether acetate, ethylene glycol monoethyl ether acetate, and ethylene glycol monobutyl ether acetate; polyethylene glycol monoalkyl ether acetates such as diethylene glycol monomethyl ether acetate, diethylene glycol monoethyl ether acetate, diethylene glycol monobutyl ether acetate, triethylene glycol monomethyl ether acetate, triethylene glycol monoethyl ether acetate, and triethylene glycol monobutyl ether acetate;

propylene glycol dialkyl ethers such as propylene glycol dimethyl ether, propylene glycol diethyl ether, and propylene glycol dibutyl ether; polypropylene glycol dialkyl ethers such as dipropylene glycol dimethyl ether, dipropylene glycol diethyl ether, dipropylene glycol dibutyl ether, tripropylene glycol dimethyl ether, tripropylene glycol diethyl ether, and tripropylene glycol dibutyl ether; propylene glycol monoalkyl ether acetates such as propylene glycol monomethyl ether acetate, propylene glycol monoethyl ether acetate, and propylene glycol monobutyl ether acetate; polypropylene glycol monoalkyl ether acetates such as dipropylene glycol monomethyl ether acetate, dipropylene glycol monoethyl ether acetate, dipropylene glycol monobutyl ether acetate, tripropylene glycol monomethyl ether acetate, tripropylene glycol monoethyl ether acetate, and tripropylene glycol monobutyl ether acetate; dialkyl ethers of copolymerized polyether glycol such as low-molecular-weight ethylene-propylene copolymers; monoacetate monoalkyl ethers of copolymerized polyether glycol; alkyl esters of copolymerized polyether glycol; and monoalkyl ester monoalkyl ethers of copolymerized polyether glycol.

Examples of the ester solvents include ethyl acetate and butyl acetate. Examples of the ketone solvents include acetone, methyl ethyl ketone, and cyclohexanone. Examples of the petroleum solvents include aromatic solvents having high boiling point, such as toluene and xylene, and aliphatic and alicyclic solvents such as hexane and cyclohexane.

Whether or not the thermosetting polyimide resin (A) is dissolved in an organic solvent can be determined by adding the polyimide resin used in the present invention to the organic solvent at a concentration of 10 mass%, leaving it to stand at 25°C for 7 days, and then visually observing the appearance.

The thermosetting polyimide resin (A) may be a polyimide resin having a linear structure or a polyimide resin having a branched structure. The thermosetting polyimide resin (A) may have, as a copolymerization component, a structure of polyester imide subjected to polyester modification or polyurethane imide subjected to urethane modification.

The polyimide resin (A) used in the present invention needs to be thermosetting, and examples of the terminal structure of the resin include structures of carboxylic acid, carboxylic acid anhydride, an isocyanate group, and an amine group. In view of high stability of the polyimide resin itself used in the present invention and high stability after the polyimide resin is mixed with an organic solvent and other resins, a structure of carboxylic acid or carboxylic acid anhydride is preferably employed as the terminal structure. In the case where the terminal structure is a structure of carboxylic acid or carboxylic acid anhydride, an acid value of 5 to 200 on a solid content basis is preferably employed for the following advantages: enabling low thermal plasticity and good cross-linking properties, being less likely to cause separation in curing of the composition, enabling production of a non-fragile cured product, and enabling good storage stability of the composition. The acid value is more preferably from 10 to 100, and further preferably 10 to 50.

The thermosetting polyimide resin (A) is preferably a polyimide rein free from an alkylene structure which reduces dimensional stability.

A phosphorus compound (B) used in the present invention has a structure represented by Formula (b1) or (b2). The inventor speculates that use of the phosphorus compound having such a structure contributes to development of the effects of the present invention for the following reasons: both the phosphorus compound (B) and the polyimide resin (A) have biphenyl backbones, and it is advantageous for enhancements in melting properties and compatibility; packing of the biphenyl backbones after thermal curing advantageously contributes to an improvement in low thermal expansion.

[Chem. 5]

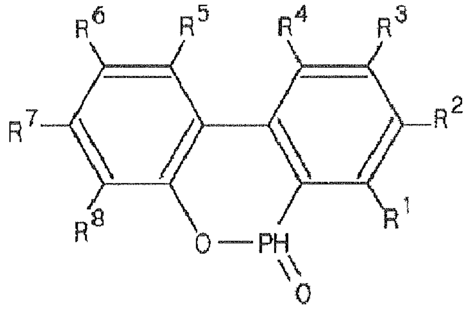

(b1)

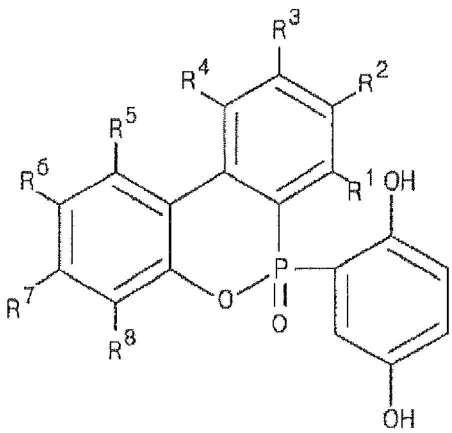

(b2)

In the phosphorus compound having the structure represented by Formula (b1) or (b2), $R^1$ to $R^8$ each represent a monofunctional aliphatic group or aromatic group and may be the same as or different from each other. $R^1$ to $R^8$ are preferably a hydrogen atom, a methyl group, an ethyl group, and a phenyl group, and more preferably a hydrogen atom and a phenyl group.

In an especially preferred phosphorus compound having the structure represented by Formula (b1), each of $R^1$ to $R^4$ is a hydrogen atom. In particular, 9,10-dihydro-9-oxa-10-phosphaphenanthrene 10-oxide is preferably employed.

In an especially preferred phosphorus compound having the structure represented by Formula (b2), each of $R^5$ to $R^8$ is a hydrogen atom. In particular, 10-(2,5-dihydroxyphenyl)-10H-9-oxa-10-phosphaphenanthrene-10-oxide is preferably employed.

The phosphorus compound (B) content in the thermosetting resin composition of the present invention is preferably 1 to 100 parts by mass relative to 100 parts by mass of the total of the thermosetting polyimide resin (A) and the epoxy resin (C) which will be described later, and more preferably 5 to 50 parts by mass in terms of the balance between melting properties and low thermal expansion.

The phosphorus compound (B) content in the thermosetting resin composition of the present invention is preferably from 1 to 10 weight%, and especially from 1 to 5 weight% on a phosphorus basis because it enables production of a cured product having high flame resistance.

Examples of the epoxy resin (C) used in the present invention include resins having two or more epoxy groups in their molecules. Examples of such epoxy resins include bisphenol epoxy resins such as a bisphenol A epoxy resin, a bisphenol S epoxy resin, and a bisphenol F epoxy resin; biphenyl-type epoxy resins; naphthalene-type epoxy resins; novolac epoxy resins such as a phenol novolac epoxy resin, a cresol novolac epoxy resin, and a bisphenol novolac resin; epoxidized materials of various dicyclopentadiene-modified phenol resins prepared by the reaction of dicyclopentadiene with a variety of phenols; epoxy resins having fluorene backbones; phosphorus-containing epoxy resins synthesized by using 10-(2,5-dihydroxyphenyl)-10H-9-oxa-10-phosphaphenanthrene-10-oxide or another material; aliphatic epoxy resins such as neopentyl glycol diglycidyl ether and 1,6-hexanediol diglycidyl ether; alicyclic epoxy resins such as 3,4-epoxycyclohexylmethyl-3,4-epoxycyclohexane carboxylate and bis-(3,4-epoxycyclohexyl)adipate; and heterocyclic epoxy resins such as triglycidyl isocyanurate. Among these epoxy resins, at least one epoxy resin selected from the group consisting of a bisphenol A epoxy resin, a bisphenol F epoxy resin, a bisphenol S epoxy resin, biphenyl-type epoxy resins, and naphthalene-type epoxy resins contributes to production of a composition which enables production of a cured product having a low linear expansion and which has excellent meltability at low temperature; hence such an epoxy resin is preferred.

The inventor speculates that use of at least one epoxy resin selected from the group consisting of a bisphenol A epoxy resin, a bisphenol F epoxy resin, a bisphenol S epoxy resin, biphenyl-type epoxy resins, and naphthalene-type epoxy resins enables production of a cured product having a low linear expansion and contributes to good meltability at low temperature for the following reasons: the biphenyl structure of the polyimide resin (A) exhibits good compatibility with the structure of bisphenol A, bisphenol F, biphenyl, or naphthalene of the epoxy resin, and the epoxy resin prevents the aggregation of the polyimide resin in a melted state while the epoxy resin and the polyimide resin closely interact with each other in a cured state with the result that a tightly cured state can be formed.

The molecular weight of the epoxy resin (C) is preferably from 300 to 1,000, and more preferably 300 to 500 in terms of the balance between the melting properties and adhesive properties and a decrease in a linear expansion coefficient.

The epoxy resin (C) content is preferably from 5 to 200 mass%, more preferably 10 to 150 mass%, and further preferably 10 to 100 mass% relative to 100 parts by mass of the polyimide resin (A) because it contributes to a production of a thermosetting resin composition which enables production of a cured product having a low linear expansion and which exhibits excellent meltability at low temperature.

The viscosity of the epoxy resin (C) is preferably not more than 12 Pa·s, and more preferably not more than 10 Pa·s at 150°C because it enables production of a composition having excellent meltability at low temperature.

Furthermore, the thermosetting resin composition of the present invention may contain a polymaleimide compound. Among polymaleimide compounds, a maleimide compound having an aromatic ring is preferably employed. The inventor believes that the melting temperature and the viscosity of the composition are decreased because a maleimide compound exhibits good compatibility with the biphenyl backbone of the thermosetting polyimide resin (A) owing to its aromatic ring; in addition, in the case where the composition is cured by a further reaction, for example, stacking interaction enables the thermosetting imide resin composition of the present invention to produce a cured product having an excellent dimensional stability and to develop an effect in which a cured product in the B-stage also has good meltability at low temperature.

A polymaleimide compound having a molecular weight of 200 to 1,000 is preferably employed. Use of a polyamide compound having a molecular weight within such a range provides an effect such as a reduction in the melt viscosity of the resin composition of the present invention, an enhancement in stability in a solution state, the anti-curl property of a film which is in the B-stage, and development of flexibility. The molecular weight is preferably in the range of 250 to 600, and more preferably 260 to 400.

Hence, among polymaleimide compounds to be added to the thermosetting resin composition of the present invention, a polymaleimide compound (D) having an aromatic ring and a molecular weight of 200 to 1,000 is preferably employed.

For example, a compound represented by the following formula can be preferably used as the polymaleimide compound (D).

[Chem. 6]

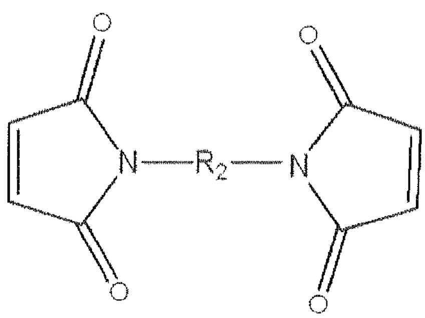

----------(d1)

($R_2$) represents a divalent organic group having an aromatic ring.

Examples of the compound represented by Formula (d1) include the following compounds.

[Chem. 7]

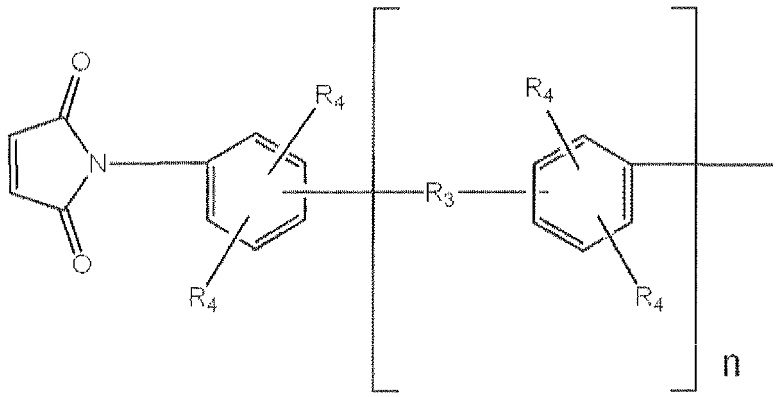

(d2)

[where $R_3$ represents a single bond or methylene, each $R_4$ represent a hydrogen atom or an alkyl group having 1 to 6 carbon atoms, and n is an integer from 0 to 4.]

Examples of the compound represented by Formula (d2) include the following compounds.

[Chem. 8]

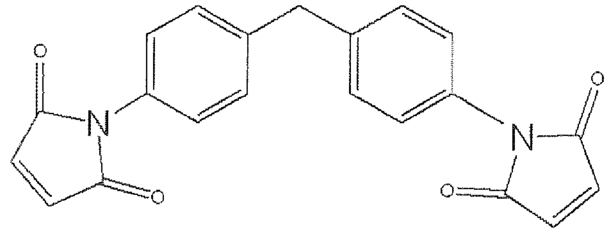

(d2-1)

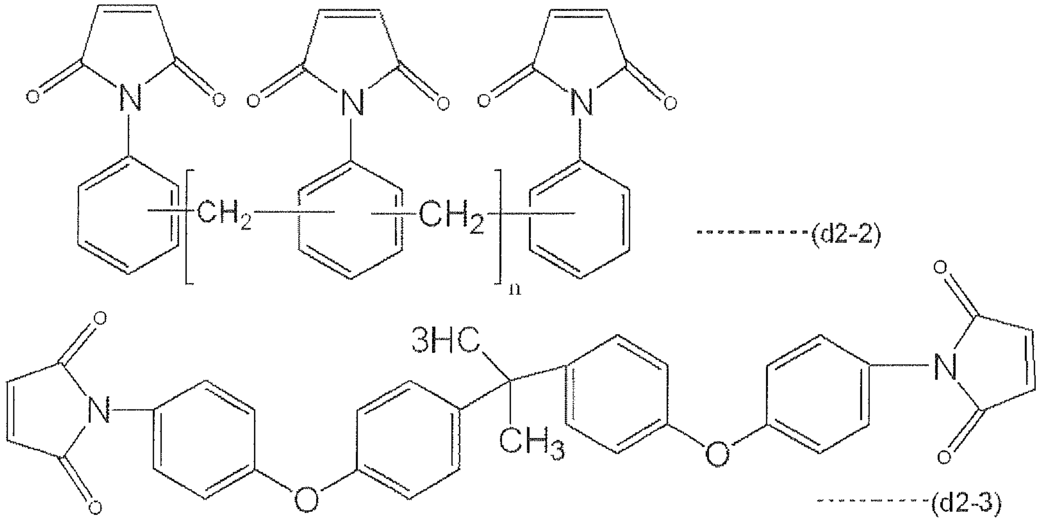

(d2-2)

(d2-3)

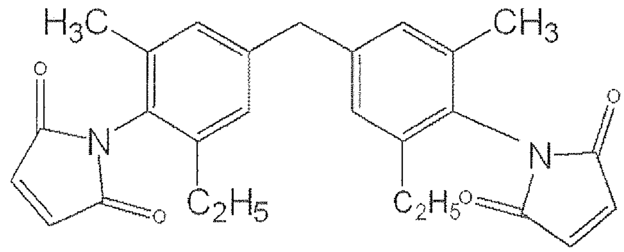

(d2-4)

[Chem. 9]

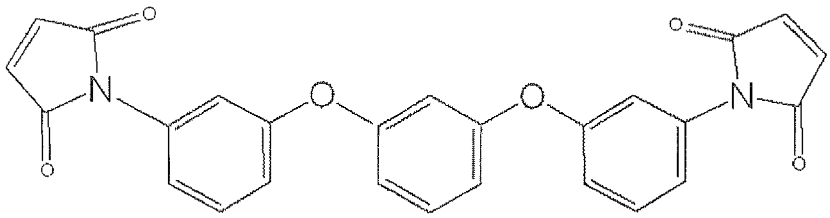

(d2-5)

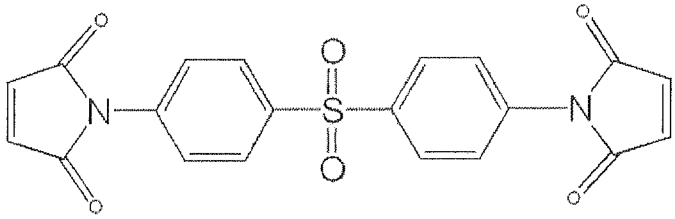

(d2-6)

[Chem. 10]

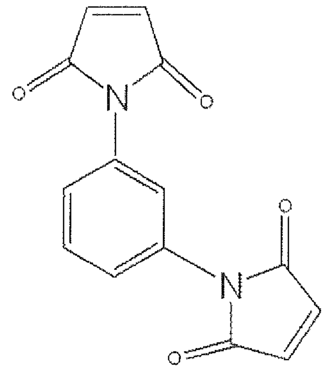

---------(d2-7)

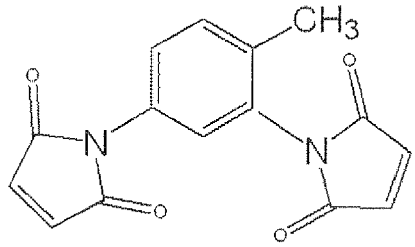

---------(d2-8)

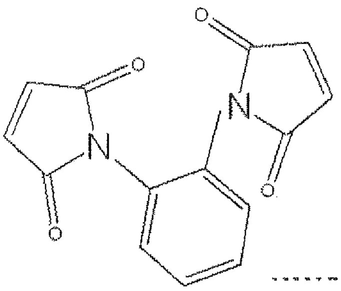

---------(d2-9)

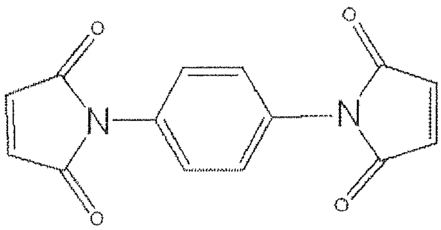

---------(d2-10)

The polymaleimide compound (D) is preferably phenylene bismaleimide or methylphenylene bismaleimide because it contributes to production of a thermosetting polyimide resin composition which enables a reduction in the melt viscosity of a cured product in the B-stage and production of a cured product exhibiting high dimensional stability in a completely cured state.

The amount of the polymaleimide compound (D) is preferably from 5 to 200 parts by mass relative to 100 parts by mass of the polyimide resin (A) because it contributes to production of a thermosetting polyimide resin composition which enables a reduction in the melt viscosity of a cured product in the B-stage and production of a cured product exhibiting high dimensional stability in a completely cured state; more preferably 10 to 100 parts by mass because it enables production of a cured product having stronger mechanical properties.

Furthermore, the thermosetting polyimide resin composition of the present invention may additionally contain a boron compound such as boric acid and/or boric acid ester. Examples of such a boron compound include boric acid; linear aliphatic boric acid esters, e.g., boric acid trialkyl esters such as trimethyl borate, triethyl borate, tributyl borate, tri-n-octyl borate, tri(triethylene glycol methyl ether)boric acid ester, tricyclohexyl borate, and trimenthyl borate; aromatic boric acid esters such as tri-o-cresyl borate, tri-m-cresyl borate, tri-p-cresyl borate, and triphenyl borate; boric acid esters containing two or more boron atoms and having a cyclic structure, such as tri(1,3-butanediol)biborate, tri(2-methyl-2,4-pentanediol)biborate, and tri(octylene glycol)diborate; polyvinyl alcohol boric acid esters; and hexylene glycol boric anhydrides.

In particular, the thermosetting polyimide resin composition of the present invention preferably contains boric

acid or a linear aliphatic boric acid ester because it enables production of a thermosetting resin composition having a high storage stability and production of a cured coating film having a high dimensional stability. Among linear aliphatic boric acid esters, boric acid trialkyl esters having 4 to 20 carbon atoms are preferred, and tributyl borate (boric acid tributyl ester) is particularly preferred.

The thermosetting polyimide resin composition of the present invention may further contain other thermosetting resin components. Specific examples thereof include phenol compounds, isocyanate compounds, silicate, alkoxysilane compounds, and melamine resins.

Preferred examples of the phenol compounds include bisphenol compounds each having two or more phenolic hydroxyl groups in its molecule, such as bisphenol A, bisphenol F, and bisphenol S; compounds each having two or more phenolic hydroxyl groups in its molecule, such as hydroquinone, 4,4'-biphenol, 3,3'-dimethyl-4,4'-biphenol, 3,3',5,5'-tetramethyl biphenol, 2,4-naphthalenediol, 2,5-naphthalenediol, and 2,6-naphthalenediol; phenol compounds containing a phosphorus atom, such as 10-(2,5-dihydroxyphenyl)-10H-9-oxa-10-phosphaphenanthrene-10-oxide; and novolac-type phenol resins such as a phenol novolac resin, a cresol novolac resin, a t-butyl phenol novolac resin, a dicyclopentadiene cresol novolac resin, a dicyclopentadiene phenol novolac resin, a xylylene-modified phenol novolac resin, a naphthol novolac resin, a trisphenol novolac resin, a tetrakis phenol novolac resin, a bisphenol A novolac resin, a poly-p-vinylphenol resin, an aminotriazine novolac-type phenol resin, and a phenol aralkyl resin. These phenol resins may be used alone or in combination. Among these phenol resins, 10-(2,5-dihydroxyphenyl)-10H-9-oxa-10-phosphaphenanthrene-10-oxide and an aminotriazine novolac-type phenol resin are preferred because they contribute to production of a composition which enables production of a cured product exhibiting high thermal resistance, high flame resistance, and low linear expansion and which exhibits excellent meltability at low temperature.

Examples of the isocyanate compound include aromatic isocyanate compounds, aliphatic isocyanate compounds, and alicyclic isocyanate compounds. A polyisocyanate compound having two or more isocyanate groups in its molecule is preferred. A blocked isocyanate compound can also be used.

Examples of the alkylalkoxysilane include alkyltrialkoxysilane and dialkyldialkoxysilane.

Examples of the alkyltrialkoxysilane include methyltrimethoxysilane, methyltriethoxysilane, methyltripropoxysilane, methyltributoxysilane, ethyltrimethoxysilane, ethyltriethoxysilane, ethyltripropoxysilane, ethyltributoxysilane, phenyltrimethoxysilane, phenyltriethoxysilane, phenyltripropoxysilane, and phenyltributoxysilane.

Examples of the dialkyldialkoxysilane include dimethyldimethoxysilane, dimethyldiethoxysilane, dimethyldipropoxysilane, dimethyldibutoxysilane, diethyldimethoxysilane, diethyldiethoxysilane, diethyldipropoxysilane, diethyldibutoxysilane, diphenyldimethoxysilane, diphenyldiethoxysilane, diphenyldipropoxysilane, diphenyldibutoxysilane, methylethyldimethoxysilane, methylethyldiethoxysilane, methylethyldipropoxysilane, methylethyldibutoxysilane, methylphenyldimethoxysilane, methylphenyldiethoxysilane, methylphenyldipropoxysilane, methylphenyldibutoxysilane, trimethylmethoxysilane, trimethylethoxysilane, triethylmethoxysilane, triethylethoxysilane, triphenylmethoxysilane, and triphenylethoxysilane.

Condensates of alkylalkoxysilane can also be used. Examples of the condensates include condensates of the above-mentioned alkyltrialkoxysilane and condensates of the above-mentioned dialkyldialkoxysilane.

An example of the melamine resin is an alkoxylated melamine resin produced through a reaction of an alcohol compound with the entire or part of a methylol compound which is produced through a reaction of formaldehyde with a triazine ring-containing amino compound such as melamine or benzoguanamine. The alcohol compound used herein is, for example, a lower alcohol having approximately 1 to 4 carbon atoms. In particular, for instance, a methoxymethylol melamine resin and a butylated methylol melamine resin can be used. Regarding the molecular structure, the melamine resin may be completely alkoxylated, the methylol group may remain, or the imino group may remain.

In the thermosetting resin composition of the present invention, this alkoxylated melamine resin not only serves as a crosslinking component to improve the heat resistance and the physical properties but also prevents added boric acid and/or boric acid ester from precipitating over time and thus enhances the stability of the thermosetting resin composition.

In terms of the resin structure of the alkoxylated melamine resin, a methoxymethylol melamine resin is preferred because it improves the compatibility with the polyimide resin and enhances the curing property in a curing process. A methoxymethylol melamine resin with a methoxylation ratio of 80% or more is more preferred.

The resin structure may be a polynuclear structure formed through self-condensation. In view of compatibility and stability, the degree of polymerization is preferably approximately from 1 to 5, and more preferably approximately 1.2 to 3.

An alkoxylated melamine resin having a number-average molecular weight of 100 to 10000 can be used. The number-average molecular weight is preferably 300 to 2000, and more preferably 400 to 1000 in terms of the compatibility with the polyimide resin and the curing property in a curing process.

The alkoxylated melamine resin may be prepared by simultaneously adding melamine or benzoguanamine, formalin, and an alcohol and then inducing a reaction or may be prepared by allowing melamine or benzoguanamine to react with formalin in advance to obtain a methylol melamine compound and then inducing alkoxylation thereof with an

alcohol compound.

Examples of commercially available alkoxylated melamine resin include methoxymethylol melamine resins; in particular, for example, CYMEL 300, 301, 303, and 305 manufactured by Nihon Cytec Industries Inc. Examples of a methoxymethylol melamine resin having a methylol group include CYMEL 370 and 771 manufactured by Nihon Cytec Industries, Inc. Examples of a methoxylated melamine resin having an imino group include CYMEL 325, 327, 701, 703, and 712 manufactured by Mitsui Cytec, Ltd. Examples of a methoxylated/butoxylated melamine resin include CYMEL 232, 235, 236, 238, 266, 267, and 285 manufactured by Nihon Cytec Industries, Inc. An example of butoxylated melamine resin is U-VAN 20SE60 manufactured by Nihon Cytec Industries, Inc.

The thermosetting polyimide resin composition of the present invention may contain binder resins such as polyester, a phenoxy resin, a PPS resin, a PPE resin, and a polyarylene resin; curing agents or reactive compounds such as a phenol resin, a melamine resin, an alkoxysilane curing agent, a polybasic acid anhydride, and a cyanate compound; curing catalysts and curing accelerators such as melamine, dicyandiamide, guanamine and derivatives thereof, imidazoles, amines, phenols having a hydroxyl group, organic phosphines, phosphonium salts, quaternary ammonium salts, and photo cationic catalysts; fillers; and other additives such as an antifoaming agent, a leveling agent, a slipping agent, a wettability-improving agent, an anti-settling agent, a flame retardant, an antioxidant, and an ultraviolet absorber.

In the thermosetting polyimide resin composition of the present invention, the cured product formed by curing the thermosetting polyimide resin composition preferably has a linear expansion coefficient of not more than 50 ppm/°C.

The thermosetting polyimide resin composition of the present invention may further optionally contain a variety of fillers, organic pigments, inorganic pigments, extenders, and corrosion inhibitors. These components may be used alone or in combination.

Examples of the fillers include barium sulfate, barium titanate, silicon oxide powder, particulate silicon oxide, silica, talc, clay, magnesium carbonate, calcium carbonate, aluminum oxide, aluminum hydroxide, mica, and alumina.

Fillers having various particle sizes can be used in an amount that does not impair the physical properties of the resin and composition. The proper amount is approximately in the range of 5 to 80% on a mass basis, and the fillers are preferably used after being uniformly dispersed. The dispersion can be carried out with a known roll or a bead mill or by high-speed dispersion, and the surfaces of the particles may be modified with a dispersing agent in advance.

Examples of the organic pigments include azo pigments, copper phthalocyanine pigments such as phthalocyanine blue and phthalocyanine green, and quinacridone pigments.

Examples of the inorganic pigments include chromic acid salts such as chrome yellow, zinc chromate, and molybdate orange; ferrocyanides such as Prussian blue; titanium oxide, zinc white, red iron oxide, and iron oxide; metal oxides such as chromium carbide green; cadmium yellow and cadmium red; metal sulfides such as mercury sulfide; selenides; sulfates such as lead sulfate; silicates such as ultramarine blue; carbonates and cobalt violet; phosphates such as manganese violet; metal powder such as aluminum powder, zinc powder, brass powder, magnesium powder, iron powder, copper powder, and nickel powder; and carbon black.

Any other coloring pigment, anticorrosive pigment, and extender can also be used. These materials may be used alone or in combination.

The cured product of the present invention is formed by curing the thermosetting polyimide resin composition of the present invention. A specific example of the cured product is a cured product produced through coating a substrate with the thermosetting polyimide resin composition of the present invention and then curing the coating film by heating at 100 to 300°C.

Any substrate can be used in the formation of the coating film. The substrate is made of, for example, a plastic material, metal, wood, glass, an inorganic material, or a composite material thereof. The substrate may be in any form, such as a sheet, a film, or a chip, or may have a three-dimensional shape.

In the present invention, the interlaminar adhesive film used for a printed wiring board includes a layer formed of the thermosetting polyimide resin composition, the layer being formed on a carrier film. Such an adhesive film may be in the form of, for example, a film (adhesive film) which includes a layer of the thermosetting polyimide resin composition of the present invention (A layer) and a support film (B layer).

The adhesive film can be produced by a variety of methods; for example, a resin varnish is prepared by dissolving the thermosetting polyimide resin composition of the present invention in an organic solvent, the resin varnish is subsequently applied onto a supporting film, and then the organic solvent is dried by heating, hot air blasting, or another technique to form a resin composition layer.

The supporting film (B layer) is a support used for producing the adhesive film. In production of a printed circuit board, the supporting film is eventually detached or removed. Examples of the supporting film include films made of polyethylene, polyolefin such as polyvinyl chloride, polyesters such as polyethylene terephthalate (hereinafter referred to as "PET" where appropriate) and polyethylene naphthalate, polycarbonate, release paper, and metal foil such as copper foil. In the case where copper foil is used as the supporting film, the copper foil can be removed by etching with an etchant composed of, for instance, ferric chloride or cupric chloride. The supporting film may be subjected to a mat

treatment, a corona treatment, or a release treatment. In view of a releasing property, the supporting film is preferably subjected to a release treatment. The supporting film may have any thickness; the thickness is normally in the range of 10 to 150 μm, and preferably 25 to 50 μm.

Examples of the organic solvent used for preparing the varnish include ketones such as acetone, methyl ethyl ketone, and cyclohexanone; acetic esters such as ethyl acetate, butyl acetate, cellosolve acetate, propylene glycol monomethyl ether acetate, and carbitol acetate; carbitols such as cellosolve and butyl carbitol; aromatic hydrocarbons such as toluene and xylene; and dimethylformamide, dimethylacetamide, N-methyl pyrrolidone, and γ-butyrolactone. These organic solvents may be used in combination.

Although the drying can be carried out under any condition, the drying is carried out such that the organic solvent content in the resin composition is normally not more than 5 mass%, and preferably not more than 3 mass%. Specific drying conditions also vary on the basis of the curing property of the resin composition and the amount of the organic solvent in the varnish; for example, a varnish containing 30 to 60 mass% of the organic solvent can be normally dried at 80 to 120°C for approximately 3 to 13 minutes. Those skilled in the art can appropriately determine suitable drying conditions through a simple experiment.

The thickness of the resin composition layer (A layer) is normally in the range of 5 to 500 μm. The preferred range of the thickness of the A layer varies on the basis of the applications of the adhesive film. In the case where the adhesive film is used to produce a multilayer flexible circuit board by a build-up process, since the thickness of a conductive layer that constitutes a circuit is normally 5 to 70 μm, the thickness of the A layer which corresponds to an interlayer insulator is preferably in the range of 10 to 100 μm.

The A layer may be protected with a protective film. The protection of the A layer with a protective film can prevent the adhesion of, for instance, dust to the surface of the resin composition layer and damage of the surface. The protective film is detached in a laminating process. The protective film can be formed of the same material as used for the supporting film. The thickness of the protective film is not particularly limited and is preferably in the range of 1 to 40 μm.

In particular, the adhesive film formed of the thermosetting polyimide resin composition of the present invention can be suitably used to produce a multilayer printed circuit board. A method for producing a printed circuit board will now be described. The adhesive film formed of the thermosetting polyimide resin composition of the present invention can be suitably laminated on a printed circuit board with a vacuum laminator. The adhesive film can be herein mainly used for printed circuit boards having a conductive layer (circuit) formed by patterning a single side or both sides of a substrate such as a fiber-reinforced prepreg, e.g., an epoxy substrate or a glass epoxy substrate; a polyester substrate; a polyimide substrate; a polyamide-imide substrate; or a liquid crystal polymer substrate. Furthermore, the adhesive film can be used to further impart a multilayer structure to multilayer printed circuit boards in which circuits and insulating layers are alternately formed and in which the circuits are formed on a single side or both sides thereof. In terms of the adhesion of the insulating layer to the circuit board, the surface of a circuit is preferably roughened with hydrogen peroxide/sulfuric acid or a surface-treating agent such as MECetchBOND (manufactured by MEC COMPANY LTD.) in advance.

Examples of commercially available vacuum laminators include Vacuum Applicator manufactured by Nichigo-Morton Co., Ltd., Vacuum & pressure laminator manufactured by MEIKI Co., Ltd., Roll-type Dry Coater manufactured by Hitachi Techno Engineering Co., Ltd., and Vacuum Laminator manufactured by Hitachi AIC Inc.

In the lamination, in the case where the adhesive film includes a protective film, the protective film is detached, and then the adhesive film is press-bonded onto the circuit board while the adhesive film is pressed and heated. The adhesive film and the circuit board are optionally preheated, and then the lamination is preferably carried out at a press-bonding temperature of preferably 70 to 140°C and a press-bonding pressure of preferably 1 to 11 $kgf/cm^2$ under a reduced air pressure of not more than 20 mmHg. The lamination may be carried out through a batch process or a continuous process using a roll.

After the adhesive film is laminated onto the circuit board, the temperature is decreased to around room temperature, and then the supporting film is detached. A thermosetting resin composition laminated onto the circuit board is subsequently cured by heating. The conditions for the curing by heating are normally selected from 150°C to 220°C and from 20 to 180 minutes and preferably selected from 160°C to 200°C and from 30 to 120 minutes. In the case where the supporting film has been subjected to a release treatment or includes a release layer composed of silicon or another material, the supporting film can be detached after the thermosetting polyimide resin composition is cured by heating or after the thermosetting polyimide resin composition is cured by heating and holes are formed.

After an insulating layer which is a cured product of the thermosetting polyimide resin composition is formed, holes may be optionally formed in the circuit board by a method involving use of a drill, laser, plasma, or a combination thereof, thereby forming via holes or through holes. Holes are typically formed with a laser such as a carbon dioxide laser or a YAG laser.

The insulating layer (cured product of the thermosetting polyimide resin composition) is subsequently subjected to a surface treatment. A technique used in a desmear process can be employed for the surface treatment, and thus the surface treatment can be carried out together with desmearing. An oxidant is typically used as an agent in a desmear

process. Examples of the oxidant include permanganates (e.g., potassium permanganate and sodium permanganate), dichromates, ozone, hydrogen peroxide/sulfuric acid, and nitric acid. The treatment is preferably carried out with an alkaline permanganate solution (e.g., an aqueous sodium hydroxide solution of potassium permanganate and sodium permanganate) which is an oxidant commonly used to roughen an insulating layer when multilayer printed wiring boards are produced through a build-up process. Before the treatment with an oxidant, a treatment with a swelling agent can be carried out. After the treatment with an oxidant, neutralization with a reductant is typically carried out.

After the surface treatment, a conductive layer is formed on the surface of the insulating layer by plating. The conductive layer can be formed by a combination of electroless plating and electrolytic plating. Alternatively, a plating resist having a pattern opposite to that of a conductive layer is formed, and a conductive layer can be formed by electroless plating alone. After the formation of the conductive layer, annealing can be carried out at 150 to 200°C for 20 to 90 minutes to further enhance and stabilize the peel strength of the conductive layer.

Examples of the method for patterning the conductive layer to form a circuit include a subtractive method and semi-additive method known by those skilled in the art. In the case of the subtractive method, the thickness of an electroless copper plating layer is from 0.1 to 3 μm, and preferably 0.3 to 2 μm. An electroplating layer (panel plating layer) is formed thereon so as to have a thickness of 3 to 35 μm, and preferably 5 to 20 μm. Then, an etching resist is formed, and etching is subsequently carried out with an etchant composed of, for example, ferric chloride or cupric chloride to form a conductive pattern. Then, the etching resist is removed to obtain a circuit board. In the case of the semi-additive method, an electroless copper plating layer is formed so as to have a thickness of 0.1 to 3 μm, and preferably 0.3 to 2 μm. Then, a pattern resist is formed and subsequently removed after electrolytic copper plating is carried out, thereby obtaining a circuit board.

A film having a structure in which the supporting film is replaced with a heat-resistant resin layer (heat-resistant resin film), in other words, a film including the layer of the thermosetting polyimide resin composition of the present invention (A layer) and a heat-resistant resin layer (C layer) can be used as a base film of a flexible circuit board. A film including the layer of the thermosetting polyimide resin composition of the present invention (A layer), the heat-resistant resin layer (C layer), and copper foil (D layer) can also be used as a base film of a flexible circuit board. In this case, the base film has a layer structure in which the A layer, the C layer, and the D layer are laminated in that order. In the base film having such a structure, the heat-resistant resin layer is not detached and constitutes part of a flexible circuit board.

A film including an insulating layer (A' layer), which is a cured product of the thermosetting polyimide resin composition of the present invention, formed on the heat-resistant resin layer (C layer) can be used as a base film of a single-sided flexible circuit board. A film having a layer structure in which the A' layer, the C layer, and the A' layer are laminated in that order and a film including the A' layer, the C layer, and the copper foil (D layer) and having a layer structure in which the A' layer, the C layer, and the D layer are laminated in that order can be used as a base film of a double-sided flexible circuit board.

Examples of a heat-resistant resin used for the heat-resistant resin layer include a polyimide resin, an aramid resin, a polyamide-imide resin, and a liquid crystal polymer. In particular, a polyimide resin and a polyamide-imide resin are preferred. In view of use of the heat-resistant resin for flexible circuit boards, a heat-resistant resin having a breaking strength of not less than 100 MPa, a rupture elongation of not less than 5%, a thermal expansion coefficient of not more than 40 ppm at 20 to 150°C, and a glass transition temperature of not less than 200°C or a decomposition temperature of not less than 300°C is preferably used.

A commercially available film-shaped heat-resistant resin can be suitably used as the heat-resistant resin that satisfies such characteristics. Examples of such a heat-resistant resin include polyimide film "UPILEX-S" manufactured by Ube Industries, Ltd., polyimide film "Kapton" manufactured by DU PONT-TORAY CO., LTD., polyimide film "Apical" manufactured by KANEKA CORPORATION, "Aramica" manufactured by Teijin Advanced Films Limited, liquid crystal polymer film "VECSTAR" manufactured by KURARAY CO., LTD., and polyetheretherketone film "SUMILITE FS-1100C" manufactured by SUMITOMO BAKELITE Co., Ltd.

The thickness of the heat-resistant resin layer is normally in the range of 2 to 150 μm, and preferably 10 to 50 μm. The heat-resistant resin layer (C layer) to be used may be surface-treated. Examples of the surface treatment include dry treatments such as a mat treatment, a corona discharge treatment, and a plasma treatment; chemical treatments such as a solvent treatment, an acid treatment, and an alkali treatment; and a sandblasting treatment and a mechanical polishing treatment. In terms of the adhesion to the A layer, a plasma treatment is particularly preferably employed.

A base film including the insulating layer (A') and the heat-resistant resin layer (C) and used for single-sided flexible circuit boards can be produced as follows. As in the above-described adhesive film, a resin varnish is prepared by dissolving the thermosetting polyimide resin composition of the present invention in an organic solvent. The resin varnish is then applied onto a heat-resistant resin film, and the organic solvent is subsequently dried by heating, hot air blasting, or another technique to form a thermosetting polyimide resin composition layer. The organic solvent and the drying conditions are the same as those of the adhesive film. The thickness of the resin composition layer is preferably in the range of 5 to 15 μm.

Then, the thermosetting polyimide resin composition layer is dried by heating to form an insulating layer composed of the thermosetting polyimide resin composition. The conditions for curing by heating are normally selected from 150°C to 220°C and from 20 to 180 minutes and preferably selected from 160°C to 200°C and from 30 to 120 minutes.

A base film having a three-layered structure which includes the insulating layer (A' layer), the heat-resistant resin layer (C layer), and the copper foil (D layer) and used for double-sided flexible circuit boards may be produced as in the above-mentioned production process except that a resin composition layer is formed on a copper-clad laminate film including the heat-resistant resin layer (C layer) and the copper foil (D layer). Examples of the copper-clad laminate film include two-layered CCLs (copper-clad laminates) formed by a cast method, two-layered CCLs formed by a sputtering method, and two-layered CCLs and three-layered CCLs formed by a lamination method. The suitable thickness of the copper foil to be used is 12 μm or 18 μm.

Examples of commercially available two-layered CCLs include ESPANEX SC (manufactured by Nippon Steel Chemical Co., Ltd.), NEOFLEX I <CM> and NEOFLEX I <LM> (manufactured by Mitsui Chemicals, Inc.), and S'PERFLEX (manufactured by Sumitomo Metal Mining Co., Ltd.). An example of commercially available three-layered CCLs is NIKAFLEX F-50VC1 (manufactured by NIKKAN INDUSTRIES CO., LTD.).

A base film having a three-layered structure which includes the insulating layer (A' layer), the heat-resistant resin layer (C layer), and the insulating layer (A' layer) and used for double-sided flexible circuit boards can be produced as follows. As in the above-described adhesive film, a resin varnish is prepared by dissolving the thermosetting polyimide resin composition of the present invention in an organic solvent. The resin varnish is then applied onto a supporting film, and the organic solvent is subsequently dried by heating, hot air blasting, or another technique to form a resin composition layer. The organic solvent and the drying conditions are the same as those of the adhesive film. The thickness of the resin composition layer is preferably in the range of 5 to 15 μm.

Then, this adhesive film is laminated on each side of the heat-resistant resin film. The lamination conditions are the same as those described above. If the resin composition layer is preliminarily formed on one side of the heat-resistant film, the lamination may be carried out only on one side. The resin composition layers are cured by heating to form insulating layers which are layers of the resin composition. The conditions for the curing by heating are normally selected from 150°C to 220°C and from 20 to 180 minutes and preferably selected from 160°C to 200°C and from 30 to 120 minutes.

A method for producing a flexible circuit board will now be described, in which the base film used for flexible circuit boards is employed. In the case where the base film includes the A' layer, the C layer, and the A' layer, after the curing by heating, holes are formed in the circuit board by a method involving use of, for instance, a drill, laser, or plasma to form through holes that serves to establish electrical connection between both sides. In the case where the base film includes the A' layer, the C layer, and the D layer, holes are formed in the same manner to form via holes. In particular, holes are typically formed with a laser such as a carbon dioxide laser or a YAG laser.

Then, the insulating layer (layer of the resin composition) is subjected to a surface treatment. The surface treatment is carried out as in the above-mentioned process involving use of the adhesive film. After the surface treatment, a conductive layer is formed on the surface of the insulating layer by plating. The formation of the conductive layer by plating is carried out as in the above-mentioned process involving use of the adhesive film. After the formation of the conductive layer, annealing can be carried out at 150 to 200°C for 20 to 90 minutes to further enhance and stabilize the peel strength of the conductive layer.

The conductive layer is subsequently patterned to form a circuit, and thus a flexible circuit board is obtained. In the case where the base film including the A layer, the C layer, and the D layer is used, a circuit is also formed on the copper foil which is the D layer. Examples of the method for forming a circuit include a subtractive method and semi-additive method known by those skilled in the art. The details are the same as those of the above-mentioned process involving use of the adhesive film.

Imparting a multilayer structure to the single-sided or double-sided flexible circuit board, which has been produced in this manner, with the adhesive film of the present invention as described above, for example, enables production of a multilayer flexible circuit board.

The resin composition of the present invention is useful as a material used for forming a layer for relaxing stress between a semiconductor and a substrate. For example, the adhesive film formed from the resin composition of the present invention is used to form the entire or part of the uppermost insulating layer overlaying a substrate in the manner described above, and then a semiconductor is bonded to this insulating layer, which enables production of a semiconductor device in which the semiconductor and the substrate adhere to each other with a cured product of the resin composition interposed therebetween. In this case, the thickness of the resin composition layer of the adhesive film is appropriately selected from 10 to 1000 μm. The resin composition of the present invention enables formation of a conductive layer by plating. Hence, a conductive layer can also be easily formed on the insulating layer by plating to form a circuit pattern, the insulating layer having been formed on the substrate for stress relaxation.

EXAMPLES

The present invention will now be described further in detail with reference to Examples. In Examples, "part" and "%" are on a mass basis unless otherwise specified.

Synthesis Example 1 [Synthesis of Polyimide Resin (A)]

Into a flask equipped with a stirrer, a thermometer, and a condenser, 213.2 g of DMAC (dimethylacetamide), 6.29 g (0.036 mol) of TDI (tolylene diisocyanate), 37.8 g (0.143 mol) of TODI (4,4'-diisocyanate-3,3'-dimethyl-1,1'-biphenyl), 29.0 g (0.151 mol) of TMA (trimellitic anhydride), 12.2 g (0.038 mol) of BTDA (benzophenone-3,3',4,4'-tetracarboxylic acid dianhydride) were supplied. The temperature was increased to 150°C for an hour under stirring without generating excessive heat, and then the content in the flask was allowed to react at this temperature for 5 hours. The reaction proceeded with bubbling of carbon dioxide gas, and a brown clear liquid was yielded in the system. A solution of a polyimide resin (a resin composition in which a polyimide resin had been dissolved in DMAC) having a viscosity of 2 Pa·s at 25°C, a resin solid content of 20%, and an acid value of 16 (KOHmg/g) on a solution basis was produced. The solution of a polyimide resin is referred to as a solution of a polyimide resin (A1). The acid value of the resin on a solid basis was calculated from these values and was 64 (KOHmg/g). The solution of the polyimide resin (A1) was subjected to gel permeation chromatography (GPC), and the weight-average molecular weight thereof was 10000.

The solution of the polyimide resin (A1) was applied onto a KBr plate, and the solvent was volatilized to produce a sample. The infrared absorption spectrum of the sample was measured; in result of the measurement, absorption at a wavelength of 2270 cm-1, which indicates the characteristic absorption of an isocyanate group, had completely disappeared, and the characteristic absorption of an imide ring was confirmed at wavelengths of 725 cm-1, 1780 cm-1, and 1720 cm-1. The amount of generated carbon dioxide gas was 15.8 g (0.36 mol), which was determined by analyzing a change in the weight of the content in the flask. Thus, it was concluded that 0.36 mol of the isocyanate group, which was the total amount of the isocyanate group, was completely converted into an imide bond and an amide bond.

Table 1 shows the amounts of the materials, the biphenyl backbone content, the logarithmic viscosity, the weight-average molecular weight, and the acid value on a solid basis in the polyimide resin (A1).

Synthesis Examples 2, 4, 5, 6, 8, and 9 [Synthesis of Polyimide Resins (A) and Comparative Polyimide Resins (a)] Solutions of polyimide resins (A2), (A4), and (A5) and solutions of comparative polyimide resins (a1), (a3), and (a4) were prepared as in Synthesis Example 1 except that the amounts of materials were changed as shown in Table 1. Table 1 shows the biphenyl backbone content, the logarithmic viscosity, the weight-average molecular weight, and the acid value on a solid basis as in Synthesis Example 1.

Synthesis Examples 3 and 8 [Synthesis of Polyimide Resin (A3) and Polyimide Resin (a2)]

Solutions of polyimide resins (A3) was prepared as in Synthesis Example 1 except that BPDA (BPDA: biphenyl-3,3',4,4'-tetracarboxylic dianhydride) was used in place of BTDA and that the amounts of materials were changed as shown in Table 1. Table 1 shows the biphenyl backbone content, the logarithmic viscosity, the weight-average molecular weight, and the acid value on a solid basis as in Synthesis Example 1.

[Table 1]

Table 1

| | Synthesis Example 1 | Synthesis Example 2 | Synthesis Example 3 | Synthesis Example 4 | Synthesis Example 5 | Synthesis Example 6 | Synthesis Example 7 | Synthesis Example 8 | Synthesis Example 9 |
|---|---|---|---|---|---|---|---|---|---|
| Polyimide resin | A1 | A2 | A3 | A4 | A5 | a1 | a2 | a3 | a4 |
| Material (g) | | | | | | | | | |
| TDI | 6.28 | 14.9 | 6.28 | 5.94 | 6.60 | 22.1 | 6.28 | 5.27 | 6.62 |
| TODI | 39.3 | 25.0 | 39.3 | 35.8 | 39.8 | 14.0 | 39.3 | 32.0 | 39.9 |
| TMA | 29.1 | 29.1 | 25.4 | 29.1 | 29.1 | 29.1 | 18.2 | 29.1 | 29.1 |
| BTDA | 12.2 | 12.2 | | 12.2 | 12.2 | 12.2 | | 12.2 | 12.2 |
| BPDA | | | 16.7 | | | | 27.8 | | |
| Amount of decarboxylation | 15.8 | 15.8 | 15.8 | 15.0 | 16.5 | 15.8 | 15.8 | 13.3 | 16.6 |
| | | | | | | | | | |
| Biphenyl content (mass%) | 31 | 22 | 43 | 30 | 30 | 13 | 48 | 28 | 31 |
| Logarithmic viscosity (dl/g) | 0.43 | 0.40 | 0.47 | 0.29 | 0.61 | 0.39 | Unmeasurable | 0.15 | 0.85 |
| Weight-average molecular weight | 10000 | 9800 | 11000 | 5000 | 56000 | 8900 | Unmeasurable | 3300 | 140000 |
| Acid value on solid basis (KOHmg/g) | 64 | 72 | 56 | 80 | 30 | 64 | Unmeasurable | 132 | 24 |

Note in Table 1
Unmeasurable: measurement was unsuccessful because precipitate was generated in the synthesis with the result that a homogeneous solution was not able to be produced.

In each of Synthesis Examples 1, 2, and 4 to 9, TODI was used as an isocyanate component having a biphenyl structure and allowed to react with the corresponding acid anhydride. In Synthesis Example 3, BPDA was used as an acid anhydride component. In each Synthesis Example, absorption of infrared spectrum by an isocyanate group was not able to be confirmed, and absorption of infrared spectrum by an acid anhydride group was confirmed only to an extent that indicated a trace; hence, it was concluded that the reaction rate was not less than 90%. Hence, it is concluded that the resin structure had a biphenyl backbone directly linked to a nitrogen atom of a five-membered cyclic imide backbone.

Examples 1 to 13 and Comparative Examples 1 to 4

Thermosetting resin compositions 1 to 13 according to the present invention and comparative thermosetting resin compositions 1' to 4' were prepared as shown in Tables 2 to 4. The TG, linear expansion coefficient, melt adhesion, and flame resistance of a cured product of each composition were evaluated. Tables 2 to 4 show results of the evaluation.

<Evaluation of Thermal Resistance (Evaluation by Measurement of TG)>

(Production of Sample)

The resin composition was applied onto a tin plate so as to have a thickness of 30 μm in a dried state. The product was dried with a dryer at 70°C for 20 minutes, cured at 200°C for an hour, and then cooled. The cured film was subsequently removed and then cut into measurement samples each having a width of 5 mm and a length of 30 mm.

(Evaluation Method)

TMA (Thermal Mechanical Analysis) was carried out with a thermal analysis system TMA-SS6000 manufactured by Seiko Instruments & Electronics Ltd. under the following conditions: the length of the samples of 10 mm, a rate of temperature increase of 10°C/min, and a load of 30 mN. The inflection point of the temperature-dimension change curve obtained in the TMA was determined, and that point was defined as TG. The higher the TG was, the more excellent thermal resistance was.

<Evaluation of Dimensional Stability (Evaluation by Measurement of Linear Expansion Coefficient)>

Samples were produced as in <Evaluation of Thermal Resistance (Evaluation by Measurement of TG)>, and TMA (Thermal Mechanical Analysis) was carried out with a thermal analysis system TMA-SS6000 under the following conditions: the length of the samples of 10 mm, a rate of temperature increase of 10°C/min, and a load of 30 mN. The linear expansion coefficient was determined from a variation in the length of the sample at a temperature ranging from 20 to 200°C. The lower the linear expansion coefficient was, the more excellent dimensional stability was.

<Evaluation of Melt Adhesion>

(Production of Sample)

The thermosetting resin composition was uniformly applied onto a PET film (thickness: 125 μm) with an applicator such that the resin composition layer had a thickness of 25 μm in a dried state. The product was dried at 100°C for 5 minutes into an adhesive film, thereby yielding a sample.

(Evaluation Method)

In order to evaluate melt adhesion, the adhesive film was bonded to electrolytic copper foil (thickness: 18 μm, surface roughness: M surface Rz of 7.4 μm and S surface Ra of 0.21 μm) such that the resin surface contacted the copper, the electrolytic copper foil having been preliminarily heated to 120°C. In the case where application of pressure was needed for the fusion-bonding, the adhesive film and the copper foil were thermally pressed at a pressure of 1.0 MPa for a minute. Then, the PET film was removed, and the product was heated at 200°C for 60 minutes to completely cure the resin composition. The resulting sample was subjected to a tape peeling test in accordance with JIS K 5400 8.5.2 (adhesion, cross-cut tape method), and melt adhesion was evaluated on the basis of the following five criteria.
A: Successful fusion-bonding at a pressure of 1.0 MPa, and the area of damaged part due to removal of the tape

from the completely cured product was less than 5% relative to the test area
B: Successful fusion-bonding at a pressure of 1.0 MPa, and the area of damaged part due to removal of the tape from the completely cured product was not less than 5% relative to the test area
C: Partially fusion-bonded at a pressure of 1.0 MPa, and the area of the fusion-bonded part was less than 50%
D: Not fusion-bonded at a pressure of 1.0 MPa at all

<Evaluation of Flame Resistance>

(Production of Sample)

The curable polyimide resin composition was applied onto a tin plate to form a coating film having a thickness of 30 μm. Then, the coated plate was dried with a dryer at 50°C for 30 minutes, 100°C for 30 minutes, and 200°C for 60 minutes to form a film. The temperature was decreased to room temperature, and the cured film was removed and cut into strips each having a width of 10 mm and a length of 80 mm, thereby producing measurement samples.

(Evaluation Method)

The strip-shaped sample was disposed such that one end thereof in the longitudinal direction was fixed to a clamp and such that the other end thereof faced downward and was vertical to the ground. The lower end was lit with a lighter, and the burning behavior of the sample was observed. Evaluation was made on the basis of the average of the lengths of the burned parts from the lit part in the tests.
A: The average of the lengths of the burned parts of the sample subjected to the test five times was less than 2 cm
B: The average of the lengths of the burned parts of the sample subjected to the test five times was 2 cm or more and less than 4 cm
C: The average of the lengths of the burned parts of the sample subjected to the test five times was 4 cm or more and less than 6 cm
D: The average of the lengths of the burned parts of the sample subjected to the test five times was not less than 6 cm

[Table 2]

Table 2

| | Example 1 | Example 2 | Example 3 | Example 4 | Example 5 | Example 6 |
|---|---|---|---|---|---|---|
| Thermosetting resin composition | 1 | 2 | 3 | 4 | 5 | 6 |
| Polyimide resin (A1) (part) | 100 | 100 | 100 | | | |
| Polyimide resin (A2) (part) | | | | 100 | | |
| Polyimide resin (A3) (part) | | | | | 100 | 100 |
| | | | | | | |
| Epoxy resin (850S) (part) | 25 | 25 | 45 | 25 | 25 | 25 |
| | | | | | | |
| HCA-HQ | 12 | | | | | 12 |
| HCA | | 12 | 24 | 12 | 12 | |
| PMB | | | 50 | | | |
| | | | | | | |
| TG (°C) | 268 | 288 | 280 | 279 | 290 | 282 |
| CTE (ppm, 20 to 150°C) | 29 | 31 | 35 | 37 | 27 | 25 |
| Melt adhesion | B | A | A | A | A | B |
| Flame resistance | A | A | A | A | A | A |

[Table 3]

Table 3

| | Example 7 | Example 8 | Example 9 | Example 10 | Example 11 | Example 12 | Example 13 |
|---|---|---|---|---|---|---|---|
| Thermosetting resin composition | 7 | 8 | 9 | 10 | 11 | 12 | 13 |
| Polyimide resin (A1) (part) | | | 100 | 100 | 100 | | |
| Polyimide resin (A4) (part) | 100 | | | | | 100 | 100 |
| Polyimide resin (A5) (part) | | 100 | | | | | |
| | | | | | | | |
| Epoxy resin (850S) (part) | 25 | 45 | | | | 45 | |
| Epoxy resin (YX4000) (part) | | | 25 | | 40 | | |
| Epoxy resin (EXA-4710) (part) | | | | 25 | | | 25 |
| | | | | | | | |
| HCA-HQ | 12 | | | | 12 | | 12 |
| HCA | | 12 | 24 | 24 | | 24 | |
| PMB | | | 50 | | 50 | 50 | |
| MPBM | | | | | | | 50 |
| | | | | | | | |
| TG (°C) | 271 | 275 | 282 | 295 | 285 | 278 | 292 |
| CTE (ppm, 20 to 150°C) | 33 | 34 | 34 | 30 | 33 | 37 | 34 |
| Melt adhesion | A | B | A | A | A | A | A |
| Flame resistance | A | A | A | A | A | A | A |

[Table 4]

Table 4

| | Comparative Example 1 | Comparative Example 2 | Comparative Example 3 | Comparative Example 4 |
|---|---|---|---|---|
| Thermosetting resin composition | 1’ | 2’ | 3’ | 4’ |
| Polyimide resin (a1) (part) | 100 | | | |
| Polyimide resin (a2) (part) | | 100 | | |

(continued)

| | Comparative Example 1 | Comparative Example 2 | Comparative Example 3 | Comparative Example 4 |
|---|---|---|---|---|
| Polyimide resin (a3) (part) | | | 100 | |
| Polyimide resin (a4) (part) | | | | 100 |
| | | | | |
| Epoxy resin (850S) (part) | | 25 | 25 | 25 |
| Epoxy resin (N680) (part) | 25 | | | |
| | | | | |
| TG (°C) | 268 | Unable to prepare composition | 261 | 268 |
| CTE (ppm, 20 to 150°C) | 57 | Unable to prepare composition | 55 | 35 |
| Melt adhesion | B | Unable to prepare composition | A | D |
| Flame resistance | C | Unable to prepare composition | D | C |

Notes in Tables 2 to 4
Epoxy resin (850S): bisphenol A liquid epoxy resin EPICLON 850-S manufactured by DIC Corporation (epoxy equivalent 188 g/eq)
YX4000: biphenyl-type epoxy resin YX4000 manufactured by Mitsubishi Chemical Corporation (epoxy equivalent 187 g/eq)
EXA-4710: naphthalene-type epoxy resin EPICLON EXA-4710 manufactured by DIC Corporation (epoxy equivalent 173 g/eq)
HCA-HQ: 10-(2,5-dihydroxyphenyl)-10H-9-oxa-10-phosphaphenanthrene-10-oxide
HCA: 9,10-dihydro-9-oxa-10-phosphaphenanthrene-10-oxide
PBM: m-phenylene bismaleimide BMI-3000H manufactured by Daiwa Fine Chemicals Co., Ltd.
MPBM: 4-methyl-1,3-phenylene bismaleimide BMI-7000 manufactured by Daiwa Fine Chemicals Co., Ltd.

Industrial Applicability

The thermosetting polyimide resin composition of the present invention exhibits excellent meltability at low temperature even after the B-stage, and, in addition, a cured product thereof exhibits low linear expansion coefficient and high dimensional stability. Furthermore, the thermosetting polyimide resin composition enables production of a cured product also exhibiting excellent flame resistance. Owing to these properties, the thermosetting polyimide resin can be used in a variety of fields.
In use of the interlaminar adhesive film used for a printed wiring board according to the present invention, the interlaminar adhesive film is press-bonded to copper foil while being melted at low temperature, so that an insulating layer in which a cured product has a low linear expansion coefficient can be formed. Hence, the interlaminar adhesive film used for a printed wiring board can be preferably used as an adhesive film to form an interlayer insulator of a multilayer printed wiring board.

## Claims

1. A thermosetting polyimide resin composition comprising a thermosetting polyimide resin (A) having a biphenyl backbone directly linked to a nitrogen atom of a five-membered cyclic imide backbone and a weight-average molecular weight (Mw) of 3,000 to 150,000, a phosphorus compound (B) represented by Formula (b1) or (b2), and an

epoxy resin (C)

[Chem. 1]

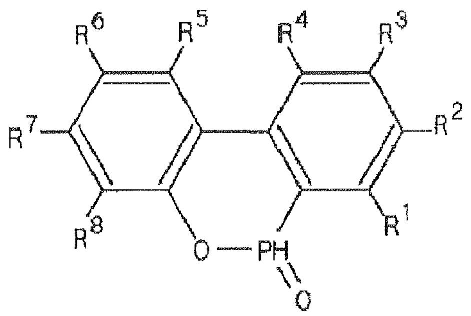

(b1)

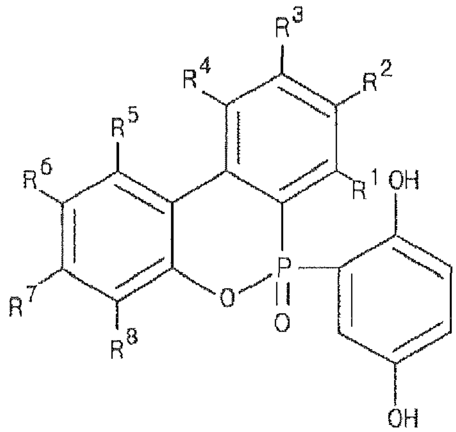

(b2)

(where $R^1$, $R^2$, $R^3$, $R^4$, $R^5$, $R^6$, $R^7$, and $R^8$ each represent a monofunctional aliphatic group or aromatic group).

2. The thermosetting polyimide resin composition according to Claim 1, wherein the biphenyl backbone content in the thermosetting polyimide resin (A) is in the range of 20 to 45 mass%, and the logarithmic viscosity of the thermosetting polyimide resin (A) is from 0.1 to 0.9 dl/g.

3. The thermosetting polyimide resin composition according to Claim 1, wherein the thermosetting polyimide resin (A) is a polyimide resin having a benzophenone structure.

4. The thermosetting polyimide resin composition according Claim 2 or 3, wherein the thermosetting polyimide resin (A) is a polyimide resin having a tolylene structure.

5. The thermosetting polyimide resin composition according to any one of Claims 1 to 4, wherein the thermosetting polyimide resin (A) is a polyimide resin that is free from an alkylene structure.

6. The thermosetting polyimide resin composition according to any one of Claims 1 to 5, wherein the thermosetting polyimide resin (A) is a polyimide resin produced through a reaction of a polyisocyanate having a biphenyl backbone with an acid anhydride.

7. The thermosetting polyimide resin composition according to Claim 6, wherein the polyisocyanate having a biphenyl backbone is tolidinediisocyanate or a polyisocyanate derived from tolidinediisocyanate.

8. The thermosetting polyimide resin composition according to Claim 1, wherein the phosphorus compound (B) content is from 1 to 100 parts by mass relative to 100 parts by mass of the total of the thermosetting polyimide resin (A) and the epoxy resins (C).

9. The thermosetting polyimide resin composition according to Claim 1, wherein the phosphorus compound (B) is

10-(2,5-dihydroxyphenyl)-10H-9-oxa-10-phosphaphenanthrene-l0-oxide or 9,10-dihydro-9-oxa-10-phosphaphenanthrene-10-oxideo.

**10.** The thermosetting polyimide resin composition according to Claim 1, wherein the epoxy resin (C) is at least one epoxy selected from the group consisting of a bisphenol A epoxy resin, a bisphenol F epoxy resin, a bisphenol S epoxy resin, a biphenyl-type epoxy resin, and a naphthalene-type epoxy resin.

**11.** The thermosetting polyimide resin composition according to any one of Claims 1 to 10, further comprising a polymaleimide compound (D) having an aromatic ring and a molecular weight of 200 to 1,000.

**12.** The thermosetting polyimide resin composition according to Claim 11, wherein the polymaleimide compound (D) is a compound represented by the following formula

[Chem. 2]

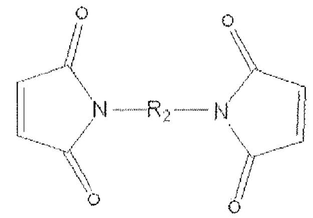

(a2)

[where ($R_2$) represents a divalent organic group having an aromatic ring].

**13.** The thermosetting polyimide resin composition according to Claim 12, wherein the compound is a compound represented by the following formula

[Chem. 3]

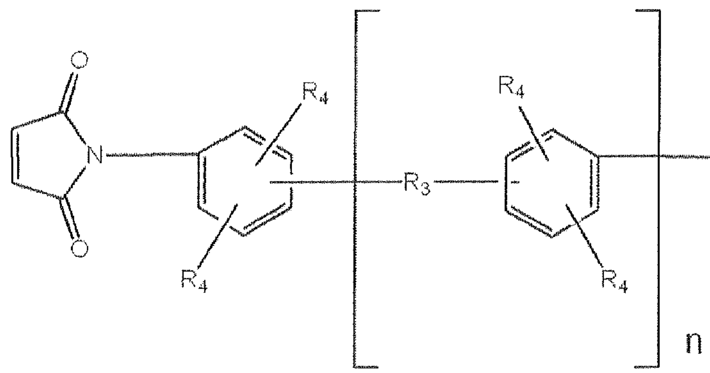

(d2)

[where $R_3$ represents a single bond or methylene, each $R_4$ represents a hydrogen atom or an alkyl group having 1 to 6 carbon atoms, and n is an integer from 0 to 4].

**14.** The thermosetting polyimide resin composition according to Claim 11, wherein the polymaleimide compound (D) is phenylene bismaleimide or methylphenylene bismaleimide.

**15.** The thermosetting polyimide resin composition according to Claim 11, wherein the polymaleimide compound (D) content is 5 to 200 parts by mass relative to 100 parts by mass of the polyimide resin (A).

**16.** A cured product produced by curing the thermosetting polyimide resin composition according to any one of Claims 1 to 15.

**17.** An interlaminar adhesive film used for a printed wiring board, the interlaminar adhesive film comprising a layer formed of the thermosetting polyimide resin composition according to any one of Claims 1 to 15, the layer being formed on a carrier film.

## INTERNATIONAL SEARCH REPORT

International application No.
PCT/JP2012/052144

A. CLASSIFICATION OF SUBJECT MATTER
*C08L63/00*(2006.01)i, *C08G59/40*(2006.01)i, *C08K5/53*(2006.01)i, *C08L79/08*(2006.01)i, *C09J11/06*(2006.01)i, *C09J163/00*(2006.01)i, *C09J179/08*(2006.01)i, *H05K1/03*(2006.01)i

According to International Patent Classification (IPC) or to both national classification and IPC

B. FIELDS SEARCHED

Minimum documentation searched (classification system followed by classification symbols)
C08L63/00, C08G59/40, C08K5/53, C08L79/08, C09J11/06, C09J163/00, C09J179/08, H05K1/03

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2012 |
| Kokai Jitsuyo Shinan Koho | 1971-2012 | Toroku Jitsuyo Shinan Koho | 1994-2012 |

Electronic data base consulted during the international search (name of data base and, where practicable, search terms used)
CA/REGISTRY(STN)

C. DOCUMENTS CONSIDERED TO BE RELEVANT

| Category* | Citation of document, with indication, where appropriate, of the relevant passages | Relevant to claim No. |
|---|---|---|
| Y | JP 2007-224242 A (Tamura Kaken Corp.), 06 September 2007 (06.09.2007), claims; paragraphs [0001], [0023] & KR 10-2007-0089053 A & CN 101029166 A | 1-17 |
| Y | WO 2010/098296 A1 (DIC Corp.), 02 September 2010 (02.09.2010), paragraph [0001]; examples; claims & TW 201035172 A | 1-17 |
| Y | JP 2010-43254 A (Hitachi Chemical Co., Ltd.), 25 February 2010 (25.02.2010), claims (Family: none) | 11-15 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 24 May, 2012 (24.05.12) | 05 June, 2012 (05.06.12) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

International application No.
PCT/JP2012/052144

C (Continuation). DOCUMENTS CONSIDERED TO BE RELEVANT

| Category* | Citation of document, with indication, where appropriate, of the relevant passages | Relevant to claim No. |
|---|---|---|
| E,X | JP 2012-72298 A (DIC Corp.), 12 April 2012 (12.04.2012), example 6 (Family: none) | 1-10,16,17 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2004168894 A
- JP 2000223805 A